# FASCICULE DE BREVET EUROPEEN

(11) **EP 4 054 771 B1**
(45) Date de publication et mention de la délivrance du brevet: **12.08.2026**
(21) Numéro de dépôt: 20816280.0
(22) Date de dépôt: 06.11.2020
(51) Int. Cl.: B05D 1/20, B82Y 30/00

(54) **MÉTHODE DE PROTECTION D'OBJETS SENSIBLES À L'AIR OU A L'EVAPORATION**
VERFAHREN ZUM SCHUTZ VON LUFTEMPFINDLICHEN ODER VERDAMPFUNGSEMPFINDLICHEN GEGENSTÄNDEN
METHOD FOR PROTECTING AIR-SENSITIVE OR EVAPORATION-SENSITIVE OBJECTS

(30) Priorité: 08.11.2019 FR 1912558
(43) Date de publication de la demande: 14.09.2022
(73) Titulaire: Commissariat à l'Energie Atomique et aux Energies Alternatives, 75015 Paris (FR)
(72) Inventeur: GABRIEL, Jean Christophe, 38950 QUAIX-EN-CHARTREUSE (FR); SPANO, Monika, 38850 CHARAVINES (FR); HAMI, Fatima-Ezzahra, 38000 GRENOBLE Cedex 9 (FR)
(74) Mandataire: Plasseraud IP
(86) Numéro de dépôt international: PCT/FR2020/052017
(87) Numéro de publication internationale: WO 2021/089957

(56) Documents cités:
- WO-A2-2007/132089
- CN-A- 105 070 515
- CN-A- 106 865 627
- JOËL AZEVEDO ET AL: "Highly Ordered Monolayer, Multilayer, and Hybrid Films of Graphene Oxide Obtained by the Bubble Deposition Method", JOURNAL OF PHYSICAL CHEMISTRY C, vol. 115, no. 30, 4 August 2011 (2011-08-04), pages 14678 - 14681, XP055063885, ISSN: 1932-7447, DOI: 10.1021/jp205020r
- JOËL AZEVEDO ET AL: "Supporting information: Highly-ordered monolayer, multilayer and hybrid films of graphene oxide by Bubble Deposition Method", 24 June 2011 (2011-06-24), XP055714266, Retrieved from the Internet <URL:https://pubs.acs.org/doi/suppl/10.1021/jp205020r/suppl_file/jp205020r_si_001.pdf> [retrieved on 20200713]

## Description

### Domaine technique

La présente divulgation relève du domaine des films minces déposés sur des substrats sensibles à l'air ou à l'évaporation tels que des cristaux de protéines.

### Contexte de l'invention

Certains substrats, tels que les cristaux de protéines ou les semi-conducteurs organiques utilisés dans les diodes électroluminescentes organiques, sont particulièrement instables et fragiles. En effet les cristaux de protéines sont instables à l'air et sont sensibles aux variations des divers paramètres physico-chimiques de leur milieu de croissance tels que le pH, la température ou la force ionique.

La sensibilité des cristaux de protéines à l'air pose un problème lorsqu'il s'agit de les isoler pour pouvoir les placer dans un faisceau de rayons X ou d'électrons afin d'en étudier la structure tridimensionnelle par diffraction des rayons X ou des électrons.

Une première solution classique pour préserver les cristaux de protéines est la cryogénie. La cryogénie consiste à mettre le cristal à étudier au bout d'un porte échantillon et le plonger dans un flux d'azote refroidi. Ce refroidissement permet d'éviter l'évaporation du solvant contenu dans le cristal, les problèmes d'instabilité thermiques du cristal et la dégradation du fait du rayonnement intense et fortement ionisant des rayons X. Cependant les cristaux de protéines, en particulier ceux comprenant une grande quantité d'eau, peuvent être sensibles à la baisse de température. En effet la baisse de température peut induire des changements de phases qui changent la structure voire détruisent les cristaux. Pour éviter ces problèmes, une huile peut être utilisée pour enrober le cristal de protéine avant de le plonger dans le flux d'azote refroidi. Cependant l'enrobage d'huile n'est pas toujours efficace et surtout génère un bruit de fond qui réduit la qualité des données enregistrées durant les analyses. Une autre solution consiste à utiliser des molécules cryoprotectices. Ces molécules cryoprotectices peuvent cependant modifier la solubilité des cristaux, la structure de la protéine et/ou la conformation de la protéine. De plus la cryogénie fonctionne d'autant plus mal que les cristaux de protéines sont gros (entre 0,1 et 1 mm³) comme c'est le cas, par exemple, pour la diffraction neutronique. Dans ce cas, les cristaux ne résistent que très rarement à la cryogénie.

Une autre solution classique consiste à déposer un film autour du substrat à protéger à partir d'une composition comprenant un tensioactif ionique. Cette solution classique est décrite dans la demande de brevet WO 2007/132089 et met en œuvre des compositions liquides dans lesquelles la concentration en tensioactif ionique est supérieure ou égale à la concentration micellaire critique (CMC) dudit tensioactif. Cette solution classique a été mise en œuvre pour déposer un film comprenant du graphène et un tensioactif ionique sur différents types de substrats (Azevedo et al. ACS Applied Materials & Interfaces 7(38) 21270-21277 (2015)), et en particulier sur des cristaux de protéines (Wierman et al. Journal of Applied Crystallography 46, 1501-1507 (2013)). Bien que le film de graphène et de tensioactif ionique puisse protéger le cristal de protéine contre l'air il n'est pas suffisamment fiable car il peut comprendre des trous.

En outre, WO2007/132089 décrit un procédé mettant en œuvre des tensioactifs mais jamais à une concentration inférieure à la CMC. , Un objectif de CN105070515 est de préparer un matériau composite en nickel et un objectif de CN106865627 est de synthétiser des nanomatériaux inorganiques mais aucun ne décrit ni ne suggère de composition liquide obtenue en mélangeant un composé lamellaire chargé avec une solution comprenant un tensioactif neutre, la concentration en tensioactif neutre dans cette solution étant inférieure à la CMC dudit tensioactif neutre

### Problème technique

Il existe donc toujours un besoin d'une solution efficace pour préserver les cristaux de protéines pour pouvoir les mettre dans un faisceau de rayons X afin d'en étudier la structure tridimensionnelle.

Il est ainsi du mérite des inventeurs d'avoir trouvé qu'il était possible de répondre à ce besoin à l'aide d'une composition liquide comprenant un tensioactive neutre et un composé lamellaire chargé.

### Résumé de l'invention

L'invention est telle que définie dans le jeu de revendications.

Ainsi un premier aspect de l'invention est un procédé de dépôt d'un film sur un substrat à partir d'une composition liquide comprenant les étapes suivantes :
a) formation d'un film à partir de la composition liquide,
b) mise en contact du film avec le substrat, et
c) dépôt du film sur le substrat,
caractérisé en ce que la composition liquide comprend un tensioactif neutre et un composé lamellaire chargé, la composition liquide est obtenue en mélangeant le composé lamellaire chargé au tensioactif neutre, et la concentration en tensioactif neutre avant le mélange avec le composé lamellaire chargé est inférieure à la concentration micellaire critique (CMC) dudit tensioactif neutre.

De façon avantageuse, la composition liquide comprenant un tensioactif neutre et un composé lamellaire chargé permet de former un film qui protège efficacement le substrat, en particulier un cristal de protéine, sur lequel ledit film est déposé par le procédé selon l'invention. En effet un cristal de protéine sur lequel un film est déposé par le procédé selon l'invention ne se dégrade pas à l'air libre pendant une durée supérieure à un mois tandis qu'un cristal de protéine sur lequel aucun film n'est déposé se dégrade en quelques minutes.

Contrairement à la cryogénie, le film déposé sur un cristal de protéine par le procédé selon l'invention ne modifie pas la solubilité dudit cristal de protéine, ne détruit pas ledit cristal de protéine et ne modifie ni la structure ni la conformation de la protéine.

De plus le film déposé sur un cristal de protéine par le procédé selon l'invention n'altère pas la qualité des analyses qui peuvent être mise en œuvre sur ledit cristal. Par exemple le film ne génère pas de bruit de fond qui réduit la qualité des données enregistrées lors de ces analyses.

Le procédé de l'invention est également adapté à la protection de gros cristaux de protéine qui, une fois le film déposé, peuvent être analysés par diffraction neutronique.

Selon un autre aspect, il est proposé un procédé d'analyse d'un substrat sur lequel un film est déposé comprenant les étapes du procédé de dépôt d'un film sur un substrat à partir d'une composition liquide et une étape d) d'analyse du substrat sur lequel un film est déposé.

Selon un autre aspect, il est proposé une composition liquide comprenant un tensioactif neutre et un composé lamellaire chargé dans laquelle :
- le tensioactif neutre est choisi parmi un tensioactif non-ionique, un tensioactif zwittérionique, un tensioactif amphotère et leurs mélanges, et
- le composé lamellaire chargé est choisi parmi une argile lamellaire, un hydroxyde lamellaire, un hydroxyde double lamellaire, H_{3(1-x-y-z)}Li₃ₓNa_{3y}K_{3z}Sb₃P₂O₁₄ avec 0 ≤ x ≤ 1 ; 0 ≤ y ≤ 1 ; 0 ≤ z ≤ 0,5 et 0 ≤ x+y+z ≤ 1, H_{(1-x-y-z)}LiₓNa_{y}K_{z}SbP₂O₈ avec 0 ≤ x ≤ 1 ; 0 ≤ y ≤ 1 ; 0 ≤ z ≤ 0,5 et 0 ≤ x+y+z ≤ 1, un oxyde lamellaire, une pérovskite lamellaire, un phosphate lamellaire, un sulfure lamellaire, un halogénure lamellaire, un carbure lamellaire et leurs mélanges, ladite composition étant susceptible d'être obtenue en mélangeant le composé lamellaire chargé avec une solution comprenant le tensioactif neutre, la concentration en tensioactif neutre dans cette solution étant inférieure à la 10 concentration micellaire critique (CMC) dudit tensioactif neutre..

### Brève description des dessins

**Fig. 1**

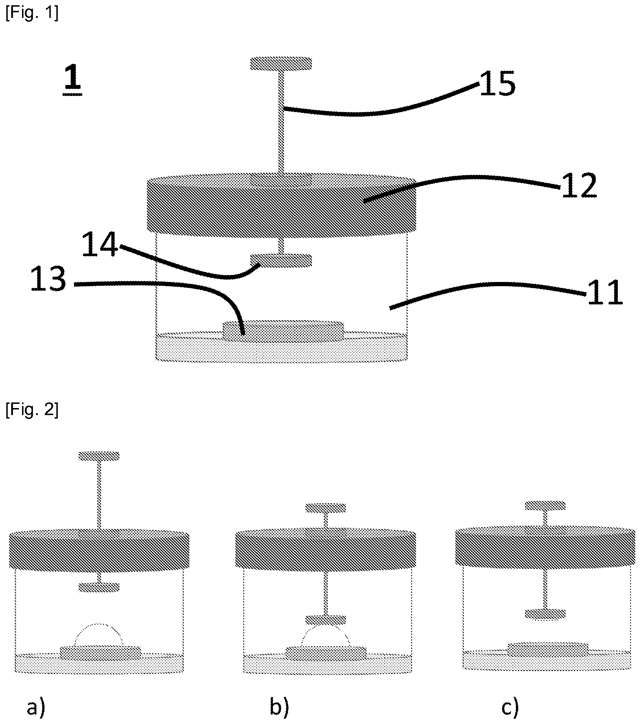

   [Fig. 1] montre un dispositif pour la mise en œuvre du procédé selon l'invention.
**Fig. 2**
   [Fig. 2] montre le dispositif lors de la mise en œuvre du procédé, *i.e.* lorsque le film est formé (Figure 2a), lors de la mise en contact du film avec le substrat (Figure 2b) et lorsque le film est déposé sur le substrat (Figure 2c).
**Fig. 3**

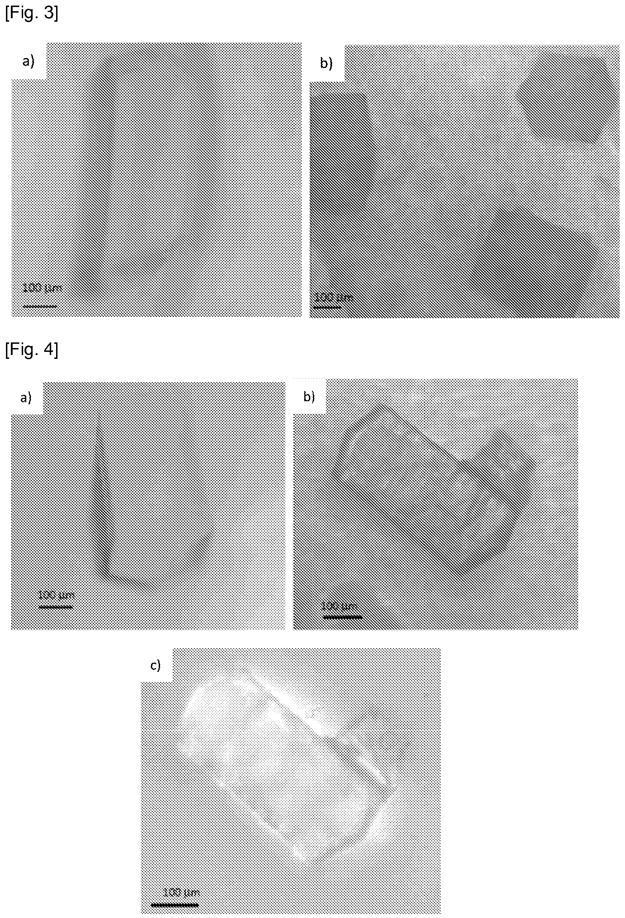

   [Fig. 3] présente des clichés de microscopie optique d'un cristal de lysozyme sur lequel aucun film n'est déposé dans ses conditions de stabilité (Figure 3a) et 5 minutes après sa mise à l'air libre (Figure 3b).
**Fig. 4**
   [Fig. 4] présente des clichés de microscopie optique d'un cristal de lysozyme sur lequel un film est déposé dans les conditions de l'Exemple 1 dans ses conditions de stabilité (Figure 4a), 5 minutes après sa mise à l'air libre (Figure 4b) et plus d'un mois après sa mise à l'air libre (Figure 4c).
**Fig. 5**

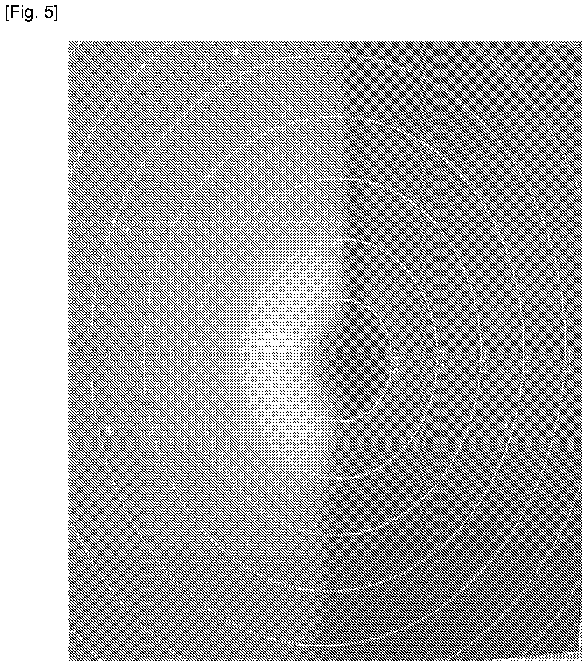

   [Fig. 5] présente un cliché de DRX monocristallin présentant le réseau réciproque d'un cristal de lysozyme sur lequel un film est déposé dans les conditions de l'Exemple 1.
**Fig. 6**

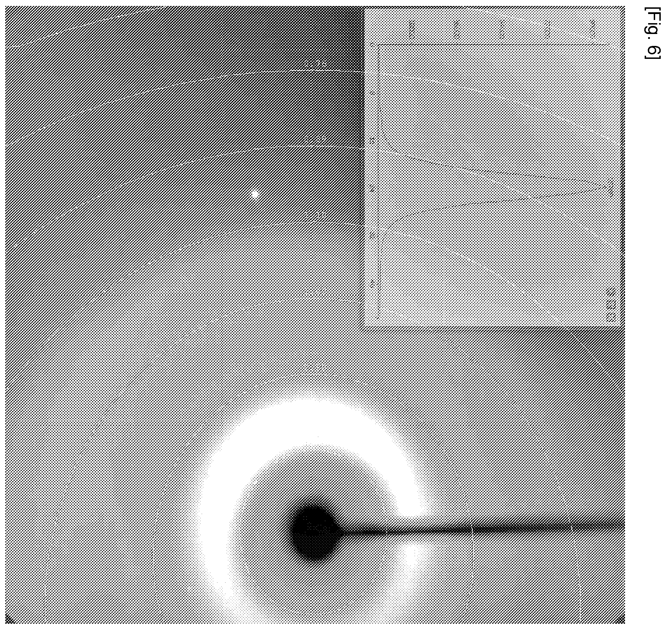

   [Fig. 6] présente un cliché de DRX monocristallin présentant un pic détecté lors de la collecte des intensités d'un cristal de lysozyme sur lequel un film est déposé dans les conditions de l'Exemple 1.

### Description détaillée de l'invention

Selon un premier aspect, l'invention est un procédé de dépôt d'un film sur un substrat à partir d'une composition liquide comprenant les étapes suivantes :
a) formation d'un film à partir de la composition liquide,
b) mise en contact du film avec le substrat, et
c) dépôt du film sur le substrat,
caractérisé en ce que la composition liquide comprend un tensioactif neutre et un composé lamellaire chargé.

Au sens de la présente invention, on entend par "composé lamellaire chargé" un composé chimique dont la structure cristalline est constituée de feuillets chargés bidimensionnels (selon les axes x et y) empilés selon la troisième dimension (selon l'axe z) et séparés par des couches ioniques. Les liaisons entre les atomes des feuillets chargés bidimensionnels sont principalement de nature covalente (directionnelle et forte) tandis que celles entre les feuillets chargés bidimensionnels et les couches ioniques sont de nature ionique (non directionnelle). Le graphène n'est pas un composé lamellaire chargé au sens de la présente invention car il ne comprend pas de couches ioniques entre des feuillets bidimensionnels.

Au sens de la présente invention, on entend par "tensioactif neutre" une molécule comprenant une partie lipophile (apolaire) et une partie hydrophile (polaire) et qui n'est pas ionisée.

Sans vouloir être liés à aucune théorie, les inventeurs sont d'avis que le film formé lors de l'étape a) comprend les feuillets du composé lamellaire chargé et le tensioactif neutre, et que, lors de l'étape c), le tensioactif neutre facilite la condensation des feuillets sur le substrat à protéger de sorte à former un film isolant et protecteur sur le substrat.

Selon un mode de réalisation, le tensioactif neutre est choisi parmi un tensioactif non-ionique, un tensioactif zwittérionique, un tensioactif amphotère et leurs mélanges, en particulier un tensioactif non-ionique.

Au sens de la présente invention, on entend par "tensioactif non-ionique" un tensioactif dont la partie lipophile et la partie hydrophile ne sont pas chargées.

Au sens de la présente invention, on entend par "tensioactif zwittérionique" un tensioactif dont l'une des parties lipophiles et hydrophiles est chargée positivement, l'autre étant chargé négativement. Le tensioactif zwittérionique est en particulier choisi parmi les composés de formule suivante :
Z⁻R1-Z⁺, dans laquelle
R1 représente une chaîne alkyle en C₁-C₂₀, en particulier en C₁-C₁₄,
Z⁻ représente une fonction chargée négativement portée par R1, en particulier parmi une fonction sulfate et carboxylate,
Z⁺ représente une fonction chargée positivement, en particulier un ammonium.
L'homme du métier saura adapter le pH de la composition liquide mise en œuvre dans le procédé de dépôt de l'invention et comprenant un tensioactif zwittérionique pour que ledit tensioactif zwittérionique soit neutre ou légèrement chargé, en particulier neutre.

Au sens de la présente invention, on entend par "tensioactif amphotère" un tensioactif dont la partie hydrophile est chargée à la fois positivement et négativement. L'homme du métier saura adapter le pH de la composition liquide mise en œuvre dans le procédé de dépôt de l'invention et comprenant un tensioactif amphotère pour que ledit tensioactif amphotère soit neutre ou légèrement chargé, en particulier neutre.

Le tensioactif non-ionique peut être tout type de tensioactif non-ionique connu de l'homme du métier. Typiquement le tensioactif non-ionique peut être un alcool éthoxylé, un alkylphénol éthoxylé, un acide gras éthoxylé, une monoalkaolamide éthoxylée, un ester de sorbitane éthoxylé, une amine éthoxylée, un ester de glycol, un ester de glycérol, un ester de polyglycérol, un ester de sorbitol, un glucoside, un polyglucoside comme un polyglucoside alkylique, un ester de sucrose, un amine oxyde tel que la lauryldimethylamine oxyde, un copolymère à blocs comportant au moins un bloc amphiphile ou leurs mélanges, en particulier un copolymère à blocs comportant au moins un bloc amphiphile.

L'alcool éthoxylé peut par exemple être un polyoxyéthylèneglycol dodécyl éther, un octaéthylène glycol monododécyl éther, un pentaéthylène glycol monododécyl éther ou leurs mélanges.

A titre d'alkylphénol éthoxylé on peut citer le polyéthylène glycol nonyl phényl éther, un polyèthylene glycol p-(1,1,3,3-tétraméthylbutyl)-phényl éther.

Typiquement l'amine éthoxylée peut être le polyoxyéthylène amine, le cocamide monoéthanolamine, le cocamide diéthanolamine ou leurs mélanges.

Par exemple, l'ester de glycérol peut être le glycérol monostéarate, le glycérol monolaurate ou leur mélange.

Typiquement l'ester de sorbitol peut être choisi parmi le monolaurate de sorbitane, le monostéarate de sorbitane, le tristéarate de sorbitane, le monolaurate de polyoxyéthylene sorbitane ou Polysorbate 20, le monopalmitate de polyoxyéthylene sorbitane ou Polysorbate 40, le monostéarate de polyoxyéthylene sorbitane ou Polysorbate 60, le tristéarate de polyoxyéthylene sorbitane ou Polysorbate 65, le monooléate de polyoxyéthylene sorbitane ou Polysorbate 80 et leurs mélanges.

Le polyglucoside alkylique peut par exemple être un décyl glucoside, un lauryl glucoside, un octyl glucoside ou leurs mélanges.

De façon générale, tout bloc amphiphile de copolymère connu de l'homme du métier peut être utilisé. On utilise en particulier un bloc amphiphile choisi parmi :
- les blocs d'unité fluorée tels que les blocs d'unité de formule -[CH₂-CH₂-CH₂-CH₂-O-CO-R2]- avec R2 = C₄F₉ ou C₈F₁₇,
- les blocs d'unité biologique tels que les blocs d'unité polyacides aminés telles que poly-lysine ou alginate,
- les blocs de motif dendrimère, et
- les blocs d'unité poly(oxyde d'alkylène) tels que les blocs d'unité poly(oxyde d'alkylène) hydrophobe et les blocs d'unité poly(oxyde d'alkylène) hydrophile,
en particulier les blocs d'unité poly(oxyde d'alkylène).

Le tensioactif peut être un copolymère à blocs ayant deux, trois ou quatre blocs, un de ces blocs étant un bloc d'unité poly(oxyde d'alkylène). Un copolymère à deux blocs peut comprendre un bloc d'unité poly(oxyde d'alkylène) hydrophile et un bloc d'unité poly(oxyde d'alkylène) hydrophobe. Un copolymère à trois blocs peut comprendre au moins un bloc d'unité poly(oxyde d'alkylène) hydrophile et au moins un bloc d'unité poly(oxyde d'alkylène) hydrophobe, en particulier deux blocs d'unité poly(oxyde d'alkylène) hydrophile et un bloc d'unité poly(oxyde d'alkylène) hydrophobe. Un copolymère à quatre blocs peut comprendre au moins un bloc d'unité poly(oxyde d'alkylène) hydrophile et au moins un bloc d'unité poly(oxyde d'alkylène) hydrophobe, en particulier deux blocs d'unité poly(oxyde d'alkylène) hydrophile et deux blocs d'unité poly(oxyde d'alkylène) hydrophobe.

Le bloc d'unité poly(oxyde d'éthylène) notée (PEO), est un exemple de bloc d'unité poly(oxyde d'alkylène) hydrophile.

A titre d'unité poly(oxyde d'alkylène) hydrophobe on peut citer le bloc d'unité poly(oxyde de propylène) notée (PPO), le bloc d'unité poly(oxyde de butylène) notée (PBO), le bloc d'unité mixte dont chaque unité est un mélange de plusieurs monomères d'oxyde d'alkylène, en particulier le bloc d'unité (PPO).

Selon un mode de réalisation particulier, le tensioactif peut être un copolymère à blocs de formule (PEO)_{w}-(PPO)_{y}-(PEO)_{z} où w est compris entre 5 et 300, y est compris entre 33 et 300 et z est compris entre 5 et 300. Par exemple les valeurs de w et z peuvent être identiques, et le tensioactif peut être un copolymère à blocs de formule (PEO)_{w}-(PPO)_{y}-(PEO)_{z} dans laquelle w = 20, y = 70 et z = 20 (P123) ou dans laquelle w = 106, y = 70 et z = 106 (F127).

Le tensioactif non-ionique peut par exemple être choisi parmi les tensioactifs non-ioniques commerciaux connus sous le nom de Pluronic (BASF) tel que le Pluronic P123, le Pluronic F127 ou leur(s) mélange(s), Tetronic (BASF), Triton (Sigma) tel que le Triton X100, le Triton X100-R ou leur mélange, Tergitol (Union Carbide), Brij (Aldrich) que le Brij 35, Tween (Roth) tel que le Tween 20, le Tween 80 ou leur(s) mélange(s.)

A titre de tensioactif zwittérionique, on peut notamment citer le N,N-diméthyldodécylammoniumbutanate de sodium, le diméthyldodécylammonium propanate de sodium et les acides aminés, le dodecylphosphocholine (C12PC), les phospholipides telles que dimyristoyl phosphatidylcholine, dipalmitoyl phosphatidylcholine, dioleoyl phosphatidylcholine, dimyristoyl phosphatidylethanolamine, dipalmitoyl phosphatidylethanolamine, dioleoyl phosphatidylethanolamine.

A titre de tensioactif amphotère, on peut notamment citer le lauroamphodiacétate de disodium, les bétaïnes comme l'alkylamidopropylbétaïne ou la laurylhydroxysulfobétaïne.

Le composé lamellaire chargé de l'invention peut être choisi parmi une argile lamellaire, un hydroxyde lamellaire, un hydroxyde double lamellaire, H_{3(1-x-y-z)}Li₃ₓNa_{3y}K_{3z}Sb₃P₂O₁₄ avec 0 ≤ x ≤ 1 ; 0 ≤ y ≤ 1 ; 0 ≤ z ≤ 0,5 et 0 ≤ x+y+z ≤ 1, H_{(1-x-y-z)}LiₓNa_{y}K_{z}SbP₂O₈ avec 0 ≤ x ≤ 1 ; 0 ≤ y ≤ 1 ; 0 ≤ z ≤ 0,5 et 0 ≤ x+y+z ≤ 1, un oxyde lamellaire, une pérovskite lamellaire, un phosphate lamellaire, un sulfure lamellaire, un halogénure lamellaire, un carbure lamellaire et leurs mélanges, en particulier H_{3(1-x-y-z)}Li₃ₓNa_{3y}K_{3z}Sb₃P₂O₁₄ avec 0 ≤ x ≤ 1 ; 0 ≤ y ≤ 1 ; 0 ≤ z ≤ 0,5 et 0 ≤ x+y+z ≤ 1, H_{(1-x-y-z)}LiₓNa_{y}K_{z}SbP₂O₈ avec 0 ≤ x ≤ 1 ; 0 ≤ y ≤ 1 ; 0 ≤ z ≤ 0,5 et 0 ≤ x+y+z ≤ 1, plus particulièrement H_{3(1-x-y-z)}Li₃ₓNa₃yK_{3z}Sb₃P₂O₁₄ avec 0 ≤ x ≤ 1 ; 0 ≤ y ≤ 1 ; 0 ≤ z ≤ 0,5 et 0 ≤ x+y+z ≤ 1, plus particulièrement encore H₃Sb₃P₂O₁₄, ou Li₃Sb₃P₂O₁₄, tout particulièrement H₃Sb₃P₂O₁₄.

Des exemples d'argile lamellaire qui peuvent être utilisés sont les argiles de la famille des smectites telles que la bentonite, la beidellite, l'hectorite, la laponite, la montmorillonite, la nontronite ou leurs mélanges, en particulier la nontronite. D'autres exemples d'argile lamellaire qui peuvent être utilisés sont les phyllosilicates tels que le mica ou la vermiculite ou leurs mélanges.

A titre d'hydroxyde lamellaire, on peut utiliser Ni(OH)₂, Co(OH)₂, Al(OH)₃ en particulier la gibbsite.

Typiquement l'hydroxyde double lamellaire (HDL) peut être choisi parmi les composés de formule [M1²⁺₁₋ₓM2³⁺ₓ(OH)₂]^{x+}(Aⁿ⁻_{x/n}).zH₂O, dans laquelle
[M1²⁺₁₋ₓM2³⁺ₓ(OH)₂]^{x+} indique que chaque feuillet de l'HDL est constitué d'une structure de type brucite (Mg(OH)₂) portant une charge nette positive (^{x+}) provenant de la substitution partielle du cation métallique trivalent M2³⁺ par un cation métallique divalent M1²⁺ ;
x, compris entre 0,17 et 0,33, est le rapport molaire M2³⁺/(M1²⁺ + M2³⁺) ;
le cation métallique divalent M1²⁺ peut être Mg²⁺, Mn²⁺, Fe²⁺, Co²⁺, Ni²⁺, Cu²⁺, Zn²⁺, Ga²⁺ ou leur(s) mélange(s) ;
le cation métallique trivalent M2³⁺ peut être Al³⁺, Cr³⁺, Mn³⁺, Fe³⁺, Co³⁺, Ni³⁺, La³⁺ ou leur(s) mélange(s) ;
l'anion interlamellaire Aⁿ⁻ peut être OH⁻, NO₃⁻, Cl⁻, ClO4⁻, CO₃²⁻, SO₄²⁻, un anion organique ou leur(s) mélange(s).

Le HDL peut également être un HDL exfoliable comme ceux décrits dans l'article de Mao et al. Applied Clay Science 144, 60-78 (2017) ou dans l'article de Hou et al. Colloids and Surfaces A: Physicochem. Eng. Aspects 312 92-98 (2008), comme par exemple l'hydroxyde double lamellaire Ni/Fe (Ni/Fe HDL) avec de l'acide amino-11-undecanoïque (AAU) en tant qu'espèce des couches ioniques, tel que par exemple Ni/Fe HDL-AAU avec Ni/Fe = 4.

L'oxyde lamellaire peut être MoO₃, MnO₂, TiO₂ en particulier la rutile, V₂O₅, WOs, ZnO ou leurs mélanges.

La pérovskite lamellaire peut, par exemple, être choisie parmi Cs_{0,7}Ti_{1,825}O₄, K_{0,45}MnO₂, K₄Nb₆O₁₇, TBAₓH₁₋ₓCa₂Nb₃O₁₀, HCa₂Nb₃O₁₀, HSr₂Nb₃O₁₀, HCaLaNb₂TiO₁₀, HLaNb₂O₇ et leurs mélanges, en particulier TBAₓH₁₋ₓCa₂Nb₃O₁₀ ou HSr₂Nb₃O₁₀, HCa₂Nb₃O₁₀, HLaNb₂O₇ et leurs mélanges.

Le phosphate lamellaire peut, par exemple, être choisi parmi les phosphates d'aluminium listés dans l'article de revue de Wang et al. Journal of Colloid and Interface Science 285 (2005) 731-736, comme par exemple [Al₃P₄O₁₆]³⁻ · 3[CH₃(CH₂)NH₃]⁺.

La composition liquide est obtenue en mélangeant le composé lamellaire chargé à une solution comprenant le tensioactif neutre, en particulier une solution aqueuse comprenant le tensioactif neutre.

Selon l'invention, la concentration en tensioactif neutre dans cette solution est inférieure à la concentration micellaire critique (CMC) dudit tensioactif neutre. La CMC du tensioactif neutre est déterminée à 25°C dans le solvant de la solution. Par exemple, la CMC du tensioactif neutre est déterminée à 25°C dans une eau déionisée présentant une résistivité de 18 Mégohm.cm lorsque la solution est une solution aqueuse.

Une concentration en tensioactif neutre inférieure à la concentration micellaire critique (CMC) dudit tensioactif neutre permet de réduire la quantité de tensioactif neutre dans le film et donc d'augmenter le ratio molaire composé lamellaire chargé/tensioactif neutre dans le film. Sans vouloir être liés à aucune théorie, les inventeurs sont d'avis que cette augmentation du ratio permet une augmentation de la quantité de feuillets du composé lamellaire chargé dans le film et améliore avantageusement la protection du substrat contre les gaz tel que l'air.

Selon un mode de réalisation particulier, la concentration en tensioactif neutre dans cette solution est inférieure à 0,95 CMC dudit tensioactif, en particulier de 0,01 CMC à 0,75 CMC dudit tensioactif, tout particulièrement de 0,15 CMC à 0,5 CMC dudit tensioactif.

Selon un mode de réalisation très particulier, le tensioactif neutre est un composé de formule (PEO)_{w}-(PPO)_{y}-(PEO)_{z} dans laquelle w = 20, y = 70 et z = 20, tel que le Pluronic P123, et sa concentration avant le mélange avec le composé lamellaire chargé est de 0,10 CMC à 0,5 CMC, en particulier de 0,15 CMC à 0,25 CMC, tout particulièrement de 0,18 CMC à 0,22 CMC. Selon Alexandridis et al. Micellization of Poly(Ethylene Oxide)-Poly(Propylene Oxide)-Poly(Ethylene Oxide) Triblock Copolymers in Aqueous-Solutions-Thermodynamics of Copolymer Association. Macromolecules 1994, 27, 2414-2425 la CMC du Pluronic P123 est de 0,052.10⁻³ M à 25°C.

La composition liquide comprend un solvant. Le solvant peut être choisi en fonction du tensioactif neutre employé. Typiquement le solvant sera choisi parmi les solvants polaires et plus particulièrement parmi les solvants protiques polaires. Ainsi par exemple le solvant peut être choisi parmi l'eau, le toluène, l'acide acétique, le méthanol, l'éthanol, l'acétonitrile, la diméthylformamide, le diméthyl Sulfoxide, le N-méthyl Formamide, le chloroforme et leurs mélanges, en particulier le solvant est de l'eau ou comprend de l'eau lorsqu'un mélange de solvant est employé.

D'une manière générale tout type de substrat peut être mis en œuvre dans le procédé selon l'invention. Ainsi il est possible de déposer par le procédé selon l'invention, un film sur un substrat organique ou un substrat inorganique.

Selon un mode de réalisation, le substrat organique peut être choisi parmi un polymère, du matériel biologique, un semi-conducteur organique et une diode électroluminescente organique (Organic Light-Emitting Diode ou OLED en anglais).

Selon un mode de réalisation, le substrat inorganique peut être choisi parmi une céramique, un oxyde d'aluminium, un substrat silicium, un matériau semi-conducteur, un métal et une diode électroluminescente (Light-Emitting Diode ou LED en anglais). Le substrat organique peut être sous forme cristalline, semi-cristalline ou amorphe.

Le substrat peut être poreux ou non poreux.

Selon un mode de réalisation particulier, le substrat est du matériel biologique choisi parmi une protéine ou un cristal de protéine. Par exemple le cristal de protéine peut être un cristal d'une protéine globulaire telle que la lysozyme, en particulier un cristal d'une protéine globulaire ayant une forte solubilité en solution de la condition de cristallisation considérée. Le cristal de protéine peut également être un cristal d'une protéine membranaire, en particulier un cristal d'une protéine membranaire ayant une faible solubilité en solution de la condition de cristallisation considérée.

Typiquement, le cristal de protéine peut présenter un volume de 0,1 mm³ à 1 mm³.

Selon un mode de réalisation particulier, le tensioactif est un composé de formule (PEO)_{w}-(PPO)_{y}-(PEO)_{z} où w est compris entre 5 et 300 et y est compris entre 33 et 300 et z est compris entre 5 et 300, le composé lamellaire chargé est H_{3(1-x-y-z)}Li₃ₓNa₃yK_{3z}Sb₃P₂O₁₄ 0 ≤ x ≤ 1 ; 0 ≤ y ≤ 1 ; 0 ≤ z ≤ 0,5 et x+y+z =1, et le substrat est un cristal de protéine.

Selon un mode de réalisation très particulier, le tensioactif est un composé de formule (PEO)_{w}-(PPO)_{y}-(PEO)_{z} dans laquelle w = 20, y = 70 et z = 20, tel que le Pluronic P123, le composé lamellaire chargé est H₃Sb₃P₂O₁₄ ou Li₃Sb₃P₂O₁₄ et le substrat est un cristal de lysozyme.

Typiquement, en fonction du substrat sur lequel le film est déposé, la composition liquide peut présenter un pH acide, neutre, ou basique. L'homme du métier saura adapter le pH de la composition liquide en fonction du substrat sur lequel le film est déposé.

Selon une première variante, la composition liquide présente un pH acide, en particulier de 2 à 6, plus particulièrement de 3 à 4. De façon avantageuse, le film formé à partir d'une composition liquide présentant un pH acide permet de stabiliser encore plus un cristal de lysozyme.

Selon une seconde variante, la composition liquide présente un pH basique, en particulier de 8 à 12, plus particulièrement de 11 à 10. Une composition liquide présentant un pH basique peut avantageusement être utilisée pour déposer un film sur des polymères ou des métaux.

L'étape a) de formation d'un film à partir de la composition liquide peut être réalisée par différents procédés connus de l'homme du métier. Par exemple, cette étape a) peut être réalisée en formant un film sous forme d'une bulle à partir de la composition liquide et en déposant ladite bulle sur un support. La bulle peut être de forme hémisphérique, on l'appelle alors demi-bulle, de forme quasi plane ou de forme concave, en particulier de forme hémisphérique. La dimension de la bulle n'est pas limitée et dépend de la dimension du substrat sur lequel le film doit être déposée. Typiquement, le rayon de la demi-bulle peut être de plusieurs dizaines de centimètre, en particulier compris entre 1 mm et 5 cm.

Cette étape a) peut également être réalisée comme l'étape de formation d'un film à partir d'une solution décrite dans la demande de brevet WO 2007/132089.

L'étape b) de mise en contact du film formé à partir de la composition liquide peut classiquement être réalisée par un mouvement relatif du substrat par rapport à la surface du film. Ainsi le substrat peut être déplacé pour établir le contact avec le film, le film peut être déplacé pour établir le contact avec le substrat ou le film et le substrat peuvent être déplacés pour établir le contact entre les deux.

Lorsque le contact est établi entre le film et le substrat il s'établit des interactions moléculaires qui permettent une adhérence importante entre le film et le substrat. L'étape c) de dépôt du film sur le substrat est alors réalisée.

Le procédé de dépôt d'un film selon l'invention peut avantageusement être réalisé dans une cellule fermée et en particulier étanche. De plus, le procédé selon l'invention peut être mis en œuvre sous une atmosphère neutre, contrôlée ou saturée en solvant de la composition liquide, en particulier sous une atmosphère saturée en solvant de la composition liquide.

De façon avantageuse, la stabilité du film durant les étapes a) et b) est augmentée lorsque le procédé est mis en œuvre sous une atmosphère saturée en solvant de la composition liquide.

Typiquement, une atmosphère contrôlée peut être une atmosphère dépourvue d'oxygène, sous azote ou sous CO₂.

Selon un mode de réalisation, les étapes a) à c) du procédé de dépôt d'un film peuvent être répétées. De façon avantageuse, la répétition des étapes a) à c) du procédé permet le dépôt d'un film multicouches dont les propriétés de protection et d'isolation peuvent être renforcées et contrôlées par rapport à un film monocouche. Un tel film multicouches est, par exemple, très intéressant dans lorsque le substrat est un semi-conducteur ou une diode électroluminescente organique.

Typiquement, les étapes a) à c) peuvent être répétées avec la même composition liquide ou avec au moins une composition liquide différente.

Selon un mode de réalisation particulier, le procédé de dépôt d'un film selon l'invention peut être mis en œuvre à l'aide d'un dispositif **1** comprenant :
- une cellule réactionnelle **11,** en particulier transparente pour permettre un suivi optique du procédé
- un couvercle **12** adapté pour isoler, en particulier de manière étanche, la cellule réactionnelle **11** du milieu extérieur,
- un support de film **13,**
- un support de substrat **14,** et
- un moyen de déplacement relatif du support de substrat **14** par rapport au support de film **13.**

Selon un autre aspect, l'invention porte sur le dispositif **1** tel que décrit ci-dessus pour le dépôt d'un film sur un substrat à partir d'une composition liquide comprenant un tensioactif neutre et un composé lamellaire chargé.

Typiquement, le dispositif **1** peut être produit par impression 3D.

Selon un mode de réalisation, le support de film **13** comprend un matériau absorbant tel qu'un ou plusieurs papiers filtrants, du tissu, ou une éponge. De façon avantageuse, ce matériau absorbant peut être imbibé de la composition liquide et ainsi stabiliser le film.

Selon un mode de réalisation alternatif, le support de film **13** peut être un anneau à bulle. De façon avantageuse, le pourtour de l'anneau à bulle permet de stabiliser le film.

Le support de substrat **14** est adapté à recevoir le substrat sur lequel le film est déposé. Il peut donc être constitué de n'importe quel matériau adapté à recevoir le substrat, ledit matériau étant choisi parmi un polymère, un verre, un métal, le kapton, le silicium, une céramique poreuse, une céramique non poreuse, un oxide d'aluminium poreux, oxide d'aluminium non poreux et leurs mélanges.

Le moyen de déplacement relatif peut être un moyen de déplacement **15** du support de substrat **14** vers le support de film **13,** un moyen de déplacement du support de film **13** vers le support de substrat **14** (non représenté sur les figures), ou les deux moyens de déplacement, en particulier le moyen de déplacement **15** du support de substrat **14** vers le support de film **13.**

Typiquement, le moyen de déplacement relatif peut permettre la translation du support de substrat **14** vers le support de film **13,** du support de film **13** vers le support de substrat **14,** ou la translation du support de substrat **14** vers le support de film **13** et la translation du support de film **13** vers le support de substrat **14.** Tous les moyens permettant cette translation peuvent être mis en œuvre dans le dispositif **1.**

Selon un mode de réalisation, le moyen de déplacement **15** comprend un vérin et un support sur lequel est placé le support de substrat **14.**

Le procédé de dépôt d'un film selon l'invention mis en œuvre par le dispositif 1 peut, par exemple, comprendre, avant l'étape a), une étape de préparation de la cellule réactionnelle **11.**

Cette étape de préparation peut, par exemple, être réalisée en immergeant partiellement le support de film **13** dans une solution comprenant le tensioactif neutre et un solvant placée dans la cellule réactionnelle **11** puis en isolant la cellule réactionnelle **11** du milieu extérieur à l'aide du couvercle **12** pendant une durée pouvant être supérieure ou égale à 0,5 min, en particulier de 2 min à 30 min, tout particulièrement de 5 min à 15 min.

De façon avantageuse, l'atmosphère la cellule réactionnelle **11** à la fin de cette étape de préparation est saturée en solvant et favorise avantageusement la stabilité du film durant les étapes a) et b).

L'étape a) du procédé selon l'invention peut être réalisée en déposant un film sur le support de film **13,** en particulier sur le support de film **13** partiellement immergé lors de l'étape de préparation.

L'étape b) du procédé selon l'invention peut ensuite être réalisée à l'aide du moyen de déplacement relatif du support de substrat **14** qui supporte le substrat sur lequel le film doit être déposé par rapport au support de film **13.** L'étape b) est en particulier réalisée à l'aide du moyen de déplacement **15.**

L'étape c) est réalisée lorsque le substrat supporté par le support de substrat **14** entre en contact avec le film sous forme de demi-bulle déposée sur le support de film **13.**

Le procédé selon l'invention peut également être mise en œuvre par le dispositif décrit dans la demande de brevet WO 2007/132089.

Le dispositif décrit dans la demande de brevet WO 2007/132089 permet avantageusement de répéter les étapes a) à c) pour déposer un film multicouches sur un substrat.

Le substrat sur lequel le film a été déposé par le procédé selon l'invention peut être analysé par toutes les techniques d'analyses connues et adaptées à l'analyse dudit substrat.

Selon un autre aspect, l'invention porte également sur un procédé d'analyse d'un substrat sur lequel un film est déposé comprenant les étapes du procédé de dépôt d'un film, qui est le premier aspect de l'invention, et une étape d) d'analyse du substrat sur lequel un film est déposé.

L'étape d) d'analyse du substrat peut être réalisée par toute technique d'analyse adaptée au substrat et connues de l'homme du métier. Par exemple l'étape d) d'analyse peut être réalisée par diffraction des rayons X, par diffraction neutronique, par résonnance par plasmons, par microscopie électronique, par microscopie à force atomique (AFM), par réflectivité des rayons X ou des neutrons, par microscopie optique confocale ou leurs mélanges.

De façon avantageuse, le procédé d'analyse selon l'invention permet de déterminer la structure d'une protéine d'un cristal de protéine grâce à la diffraction des rayons X et la diffraction neutronique.

Selon un autre aspect, l'invention porte sur une composition liquide comprenant un tensioactif neutre et un composé lamellaire chargé.

La composition liquide selon cet autre aspect de l'invention est telle que décrite ci-dessus en lien avec le procédé de dépôt d'un film, qui est le premier aspect de l'invention.

### Exemples

### Exemple 1 : Le substrat est un cristal de Lysozyme

### Exemple 1-1 : Dépôt d'un film obtenu à partir de Pluronic P123 (tensioactif non-ionique) et de H₃Sb₃P₂O₁₄ (composé lamellaire chargé) sur un cristal de lysozyme (substrat).

### Le dispositif 1.

Le dispositif 1 mis en œuvre dans l'Exemple 1 est illustré par la Figure 1. Le dispositif 1 comprend une cellule réactionnelle **11** transparente pour permettre un suivi optique, un couvercle **12** adapté pour isoler de manière étanche la cellule réactionnelle **11** du milieu extérieur et comprenant un orifice débouchant, un support de film **13** constitué de papiers filtres superposés, un support de substrat **14** qui est une plaque de verre, et un moyen de déplacement **15** du support de substrat **14** vers le support de film **13.** Le moyen de déplacement **15** comprend un vérin et un support sur lequel est placé le support de substrat **14** et traverse le couvercle **12** via l'orifice débouchant du couvercle **12.**

### La composition liquide comprenant Pluronic P123 et H₃Sb₃P₂O₁₄

La composition liquide mise en œuvre dans cet Exemple 1 est obtenue en mélangeant 1 mL de H₃Sb₃P₂O₁₄ d'une concentration massique de 16 mg/mL avec 1 mL de Pluronic P123 d'une concentration égale à 0,2 CMC.

### Le protocole opératoire.

Le protocole opératoire suivi durant l'Exemple 1 est illustré par la Figure 2.

9 ml d'une solution aqueuse de Pluronic P123 ont été versés dans la cellule réactionnelle **11** afin de saturer l'atmosphère de la cellule réactionnelle **11** en vapeur d'eau. Ensuite, le support de film **13** (superposition de papiers filtrants) a été partiellement immergé dans la solution de Pluronic P123 au centre de la cellule réactionnelle **11.** Puis, la cellule réactionnelle **11** est fermée par le couvercle **12** pendant plus de 10 minutes pour que l'atmosphère de la cellule réactionnelle **11** soit saturée en eau et ainsi avoir les conditions de stabilisation du film sous forme de demi-bulle. Une pipette pasteur est utilisée pour la réalisation de la demi-bulle. Un très petit volume (inférieure à 1 mL) de la composition liquide comprenant Pluronic P123 et H₃Sb₃P₂O₁₄, est prélevé avec la pipette pasteur. La pipette pasteur est placée juste au-dessus du support de film **13.** Un film sous forme de demi-bulle est formé et déposé au centre du support de film **13** (Figure 2a), juste après formation du film sous forme de demi-bulle, l'eau contenue dans le film commence à drainer sur les bords du film. Après 2 minutes de drainage, le cristal de lysozyme présent sur le support de substrat **14** est approché du sommet du film sous forme de demi-bulle grâce au moyen de déplacement **15** jusqu'à la mise en contact du film avec le cristal de lysozyme (Figure 2b). L'adhésion du film s'accompagne de son étalement puis son éclatement presque instantanément. Un film est alors déposé sur le cristal de lysozyme (Figure 2c). Le cristal de lysozyme est ensuite décollé du support de substrat **14** et laissé sécher à l'air libre.

### Exemple comparatif 1 : Dépôt d'un film obtenu à partir d'un tensioactif ionique (dodécylsulfate de sodium) et du H₃Sb₃P₂O₁₄ (composé lamellaire chargé) sur un cristal de cristal de lysozyme (substrat).

Le même dispositif et le même protocole opératoire que dans l'Exemple 1 sont suivis, la différence étant que le tensioactif non-ionique neutre, Pluronic P123, est remplacé par un tensioactif ionique, le dodécylsulfate de sodium, dans la composition liquide.

Il n'est pas possible de former le film sous forme de demi-bulle et donc de le déposer au centre du support de film 13. En effet, les nanoparticules de H₃Sb₃P₂O₁₄ floculent lors du mélange avec le dodécylsulfate de sodium.

### Exemple 1-2: Etude comparative entre la stabilité à l'air libre d'un cristal de lysozyme obtenu lors de l'Exemple 1-1 et d'un cristal de lysozyme sur lequel aucun film n'est déposé.

Les cristaux de lysozyme ont été observés avant et après le dépôt du film sous microscope optique à lumière polarisée (Axio Scope.A1).

La Figure 3 met en évidence qu'au bout de 5 minutes le cristal sur lequel aucun film n'est déposé est dégradé et des cristaux de sels du buffer ont cristallisé.

La Figure 4 met en évidence que le cristal obtenu lors de l'Exemple 1 n'est pas dégradé même après un mois. En effet, le cristal garde sa morphologie générale et reste biréfringent et transparent même après un mois.

Ainsi les résultats obtenus ont montré que si le cristal sur lequel aucun film n'est déposé est mis à l'air libre alors il se dégrade en 5 minutes tandis que le cristal de l'Exemple 1 résiste à l'air libre pendant une durée supérieure à un mois.

### Exemple 1-3: Etude de la cristallinité du cristal de lysozyme obtenu lors de l'Exemple 1-1.

Les analyses par Diffraction des Rayons X (DRX) monocristallin ont été réalisées sur le cristal obtenu lors de l'Exemple 1, quatre jours après le dépôt du film.

Les analyses par DRX sur monocristal ont été effectuées avec le système Oxford Diffraction X calibur, avec une source monochromatique de rayons X (anode de cuivre) et un détecteur CCD. L'instrument est contrôlé par ordinateur avec le logiciel CrysAlisPro pour l'analyse des données. La plaque de verre (lamelle de microscope) sur laquelle se situe le cristal a été collée sur un porte échantillon rigide puis le cristal a été centré dans le faisceau de rayon X.

Les résultats obtenus par DRX ont mis en évidence que l'échantillon est encore cristallin 4 jours après le dépôt du film. En effet, les clichés de DRX présentent le réseau réciproque du cristal (Figure 5) et un de nombreux pics de diffraction du cristal(Figure 6). En particulier, les clichés collectés présentent des pics intenses avec un facteur de I/sigma = 60 pour le premier pic observé. Ceci prouve l'existence d'un ordre cristallin dans le cristal de protéine. Ce résultat démontre que, sur le plan cristallographique, la conservation du cristal est très significativement améliorée par rapport à ce qui peut être fait actuellement dans l'état de l'art sur des cristaux millimétriques en absence de la solution mère de cristallisation.

### Exemple 2 : Le substrat est une plaquette en acier

### Exemple 2.1 : Dépôt d'un film obtenu à partir de Pluronic P123 (tensioactif non-ionique) et de H₃Sb₃P₂O₁₄ (composé lamellaire chargé).

Le dispositif **1** mis en œuvre dans l'Exemple 1 est utilisé dans cet Exemple 2.

La composition liquide mise en œuvre dans cet Exemple 2.1 est obtenue en mélangeant 1 mL de H₃Sb₃P₂O₁₄ d'une concentration massique de 16 mg/mL avec 1 mL de Pluronic P123 d'une concentration égale à 0,16 CMC. Cet Exemple 2.1 est réalisé à 20°C.

Le substrat mis en œuvre dans cet Exemple 2 est une plaquette en acier commerciale non polie de longueur égale à 2,5 cm, de largueur égale à 1,5 cm et de hauteur égale à 0,2 cm.

Le substrat est d'abord nettoyé avec de l'éthanol. Il est ensuite accroché au support de substrat **14.** Pour atteindre les conditions de stabilisation optimales de la bulle, 1 ml de la composition liquide a été versé dans la cellule réactionnelle **11.** Le support de film **13** (superposition de papiers filtrants) imbibé par la composition liquide est placé au milieu de la cellule réactionnelle **11.** Ce dernier sert de support sur lequel vient se poser le film sous forme de demi-bulle avant de le déposer sur le substrat. La cellule réactionnelle **11** est fermée par le couvercle **12** pendant environ 5 minutes pour que l'atmosphère de la cellule réactionnelle **11** soit saturée en eau et ainsi avoir les conditions de stabilisation du film sous forme de demi-bulle. Un film sous forme de demi-bulle est ensuite déposé sur le support de film **13** et laissé drainer pour une dizaine de secondes. Le substrat est ensuite approché du sommet du film sous forme de demi-bulle. Ce dernier adopte une géométrie quasi-cylindrique qui éclate instantanément. Un film est alors déposé sur le substrat. Cette procédure a été refaite plusieurs fois pour le dépôt d'un film multicouches sur le substrat. Après dépôt du film multicouches, le substrat est placé sur une plaque chauffante à 70°C pendant 30 min.

### Exemple 2.2 : Etude comparative de l'effet anti-corrosion de la plaquette obtenue lors de l'Exemple 2-1 et d'une plaquette d'acier sur laquelle aucun film multicouches n'a été déposé.

De l'acide chlorhydrique diluée (0,001 M) est utilisée pour accélérer l'effet corrosion.

Une goutte d'acide chlorhydrique diluée a été versée sur la .plaquette obtenue lors de l'Exemple 2-1 et sur une plaquette d'acier sur laquelle aucun film multicouches n'a été déposé.

La goutte d'acide chlorhydrique ne corrode pas la plaquette obtenue lors de l'Exemple 2-1. En revanche, la goutte d'acide chlorhydrique corrode la plaquette sur laquelle aucun film multicouches n'a été déposé.

## Revendications

1. Procédé de dépôt d'un film sur un substrat à partir d'une composition liquide comprenant les étapes suivantes :
a) formation d'un film à partir de la composition liquide,
b) mise en contact du film avec le substrat, et
c) dépôt du film sur le substrat
**caractérisé en ce que** la composition liquide comprend un tensioactif neutre et un composé lamellaire chargé,
la composition liquide est obtenue en mélangeant le composé lamellaire chargé au tensioactif neutre, et
la concentration en tensioactif neutre avant le mélange avec le composé lamellaire chargé est inférieure à la concentration micellaire critique (CMC) dudit tensioactif neutre.

2. Procédé de dépôt selon la revendication 1 dans lequel le tensioactif neutre est choisi parmi un tensioactif non-ionique, un tensioactif zwittérionique, un tensioactif amphotère et leurs mélanges.

3. Procédé de dépôt selon la revendication 2 dans lequel le tensioactif neutre est un tensioactif non-ionique choisi parmi un alcool éthoxylé, un alkylphénol éthoxylé, un acide gras éthoxylé, une monoalkaolamide éthoxylée, un ester de sorbitane éthoxylé, une amine éthoxylée, un ester de glycol, un ester de glycérol, un ester de polyglycérol, un ester de sorbitol, un glucoside, un polyglucoside, un ester de sucrose, un amine oxyde, un copolymère à blocs comportant au moins un bloc amphiphile et leurs mélanges.

4. Procédé de dépôt selon la revendication 3 dans lequel le tensioactif non-ionique est un copolymère à blocs comportant au moins un bloc amphiphile choisi parmi les blocs d'unité fluorée, les blocs d'unité biologique, les blocs d'unité dendrimères, et les blocs d'unité poly(oxyde d'alkylène)).

5. Procédé de dépôt selon l'une quelconque des revendications 1 à 4 dans lequel le composé lamellaire chargé est choisi parmi une argile lamellaire, un hydroxyde lamellaire, un hydroxyde double lamellaire, H_{3(1-x-y-z)}Li₃ₓNa_{3y}K_{3z}Sb₃P₂O₁₄ avec 0 ≤ x ≤ 1 ; 0 ≤ y ≤ 1 ; 0 ≤ z ≤ 0,5 et 0 ≤ x+y+z ≤ 1, H_{(1-x-y-z)}LiₓNa_{y}K_{z}SbP₂O₈ avec 0 ≤ x ≤ 1 ; 0 ≤ y ≤ 1 ; 0 ≤ z ≤ 0,5 et 0 ≤ x+y+z ≤ 1, un Réponse à la communication selon les Règles 161(1) et 162 CBE oxyde lamellaire, une pérovskite lamellaire, un phosphate lamellaire, un sulfure lamellaire, un halogénure lamellaire, un carbure lamellaire et leurs mélanges.

6. Procédé de dépôt selon l'une quelconque des revendications 1 à 5 dans lequel le substrat est un substrat organique ou un substrat inorganique.

7. Procédé de dépôt selon la revendication 6 dans lequel le substrat organique est choisi parmi un polymère, du matériel biologique, un semi-conducteur organique, et une diode électroluminescente organique.

8. Procédé de dépôt selon la revendication 6 dans lequel le substrat inorganique est choisi parmi une céramique, un oxyde d'aluminium, un substrat silicium, un matériau semi-conducteur, un métal et une diode électroluminescente.

9. Procédé de dépôt selon l'une quelconque des revendications 1 à 8 dans lequel le tensioactif neutre est un composé de formule (PEO)_{w}-(PPO)_{y}-(PEO)_{z} où w est compris entre 5 et 300 et y est compris entre 33 et 300 et z est compris entre 5 et 300, le composé lamellaire chargé est H_{3(1-x-y-z)}Li₃ₓNa_{3y}K_{3z}Sb₃P₂O₁₄ avec avec0 ≤ x ≤ 1 ; 0 ≤ y ≤ 1 ; 0 ≤ z ≤ 0.5 et x+y+z =1 et le substrat est un cristal de protéine.

10. Procédé de dépôt selon l'une quelconque des revendications 1 à 9 dans lequel les étapes a) à c) sont répétées.

11. Procédé d'analyse d'un substrat sur lequel un film est déposé comprenant les étapes du procédé de dépôt d'un film tel que défini selon l'une quelconques des revendications 1 à 10 et une étape d) d'analyse du substrat sur lequel un film est déposé.

12. Composition liquide comprenant un tensioactif neutre et un composé lamellaire chargé dans laquelle :
- le tensioactif neutre est choisi parmi un tensioactif non-ionique, un tensioactif zwittérionique, un tensioactif amphotère et leurs mélanges, et
- le composé lamellaire chargé est choisi parmi une argile lamellaire, un hydroxyde lamellaire, un hydroxyde double lamellaire, H_{3(1-x-y-z)}Li₃ₓNa_{3y}K_{3z}Sb₃P₂O₁₄ avec 0 ≤ x ≤ 1 ; 0 ≤ y ≤ 1 ; 0 ≤ z ≤ 0,5 et 0 ≤ x+y+z ≤ 1, H_{(1-x-y-z)}LiₓNa_{y}K_{z}SbP₂O₈ avec 0 ≤ x ≤ 1 ; 0 ≤ y ≤ 1 ; 0 ≤ z ≤ 0,5 et 0 ≤ x+y+z ≤ 1, un oxyde lamellaire, une pérovskite lamellaire, un phosphate lamellaire, un sulfure Réponse à la communication selon les Règles 161(1) et 162 CBE lamellaire, un halogénure lamellaire, un carbure lamellaire et leurs mélanges, ladite composition étant susceptible d'être obtenue en mélangeant le composé lamellaire chargé avec une solution comprenant le tensioactif neutre, la concentration en tensioactif neutre dans cette solution étant inférieure à la concentration micellaire critique (CMC) dudit tensioactif neutre.

13. Composition liquide selon la revendication 12 dans laquelle le tensioactif neutre est un tensioactif non-ionique choisi parmi un alcool éthoxylé, un alkylphénol éthoxylé, un acide gras éthoxylé, une monoalkaolamide éthoxylée, un ester de sorbitane éthoxylé, une amine éthoxylée, un ester de glycol, un ester de glycérol, un ester de polyglycérol, un ester de sorbitol, un glucoside, un polyglucoside comme un polyglucoside alkylique, un ester de sucrose, un amine oxyde tel que la lauryldimethylamine oxyde, un copolymère à blocs comportant au moins un bloc amphiphile.

14. Composition liquide selon la revendication 13 dans laquelle le tensioactif non-ionique est un copolymère à blocs comportant au moins un bloc amphiphile choisi parmi les blocs d'unité fluorée, les blocs d'unité biologique, les blocs d'unité dendrimères, et les blocs d'unité poly(oxyde d'alkylène).

## Patentansprüche

1. Verfahren zum Aufbringen eines Films auf ein Substrat aus einer flüssigen Zusammensetzung, das die folgenden Schritte umfasst:
a) Bildung eines Films aus der flüssigen Zusammensetzung,
b) Inkontaktbringen des Films mit dem Substrat, und
c) Aufbringen des Films auf das Substrat,
**dadurch gekennzeichnet, dass** die flüssige Zusammensetzung ein neutrales Tensid und eine geladene lamellare Verbindung umfasst,
die flüssige Zusammensetzung durch Mischen der geladenen lamellaren Verbindung mit dem neutralen Tensid erhalten wird, und
die Konzentration des neutralen Tensids vor dem Mischen mit der geladenen lamellaren Verbindung unterhalb der kritischen Mizellkonzentration (CMC) des neutralen Tensids liegt.

2. Aufbringungsverfahren nach Anspruch 1, wobei das neutrale Tensid aus einem nichtionischen Tensid, einem zwitterionischen Tensid, einem amphoteren Tensid und deren Mischungen gewählt ist.

3. Aufbringungsverfahren nach Anspruch 2, wobei das neutrale Tensid ein nichtionisches Tensid ist, das gewählt ist aus einem ethoxylierten Alkohol, einem ethoxylierten Alkylphenol, einer ethoxylierten Fettsäure, einem ethoxylierten Monoalkoholamid, einem ethoxylierten Sorbitanester, einem ethoxylierten Amin, einem Glykolester, einem Glycerinester, einem Polyglycerinester, einem Sorbitolester, einem Glucosid, einem Polyglucosid, einem Saccharoseester, einem Aminoxid, einem Blockcopolymer, das wenigstens einen amphiphilen Block umfasst sowie deren Mischungen.

4. Aufbringungsverfahren nach Anspruch 3, wobei das nichtionische Tensid ein Blockcopolymer ist, das wenigstens einen amphiphilen Block umfasst, der aus Blöcken mit Fluoreinheit, Blöcken mit biologischer Einheit, Blöcken mit Dendrimer-Einheit und Blöcken mit Poly(alkylenoxid)-Einheit gewählt ist.

5. Aufbringungsverfahren nach einem der Ansprüche 1 bis 4, wobei die geladene lamellare Verbindung gewählt ist aus einem lamellaren Ton, einem lamellaren Hydroxid, einem doppellamellaren Hydroxid, H_{3(1-x-y-z)}Li₃ₓNa_{3y},K_{3z}Sb₃P₂O₁₄ mit 0 ≤ x ≤ 1; 0 ≤ y ≤ 1; 0 ≤ z ≤ 0,5 und 0 ≤ x+y+z ≤ 1, H_{(1-x-y-z)}LiₓNa_{y},K_{z}SbP₂O₈ mit 0 ≤ x ≤ 1; 0 ≤ y ≤ 1; 0 ≤ z ≤ 0,5 und 0 ≤ x+y+z ≤ 1, einem lamellaren Oxid, einem lamellaren Perowskit, einem lamellaren Phosphat, einem lamellaren Sulfid, einem lamellaren Halogenid, einem lamellaren Karbid und deren Mischungen.

6. Aufbringungsverfahren nach einem der Ansprüche 1 bis 5, wobei das Substrat ein organisches oder ein anorganisches Substrat ist.

7. Aufbringungsverfahren nach Anspruch 6, wobei das organische Substrat aus einem Polymer, biologischem Material, einem organischen Halbleiter und einer organischen Leuchtdiode gewählt ist.

8. Aufbringungsverfahren nach Anspruch 6, wobei das anorganische Substrat aus Keramik, Aluminiumoxid, einem Siliziumsubstrat, einem Halbleitermaterial, einem Metall und einer Leuchtdiode gewählt ist.

9. Aufbringungsverfahren nach einem der Ansprüche 1 bis 8, wobei das neutrale Tensid eine Verbindung der Formel (PEO)_{w}-(PPO)_{y}-(PEO)_{z} ist, wobei w zwischen 5 und 300 liegt und y zwischen 33 und 300 liegt und z zwischen 5 und 300 liegt, wobei die geladene lamellare Verbindung H_{3(1-x-y-z)}Li₃ₓNa_{3y},K_{3z}Sb₃P₂O₁₄ mit 0 ≤ x ≤ 1; 0 ≤ y ≤ 1; 0 ≤ z ≤ 0,5 und 0 ≤ x+y+z ≤ 1 ist, und das Substrat ein Proteinkristall ist.

10. Aufbringungsverfahren nach einem der Ansprüche 1 bis 9, wobei die Schritte a) bis c) wiederholt werden.

11. Verfahren zur Analyse eines Substrats, auf dem ein Film aufgebracht ist, das die Schritte des Verfahrens zur Aufbringung eines Films umfasst, wie in einem der Ansprüche 1 bis 10 definiert, und einen Schritt d) zur Analyse des Substrats, auf dem ein Film aufgebracht ist.

12. Flüssige Zusammensetzung, die ein neutrales Tensid und eine geladene lamellare Verbindung umfasst, wobei:
- das neutrale Tensid aus einem nichtionischen Tensid, einem zwitterionischen Tensid, einem amphoteren Tensid und deren Mischungen gewählt ist, und
- die geladene lamellare Verbindung gewählt ist aus einem lamellaren Ton, einem lamellaren Hydroxid, einem doppellamellaren Hydroxid, H_{(1-x-y-z)}Li₃ₓNa_{3y},K_{3z}Sb₃P₂O₁₄ mit 0 ≤ x ≤ 1; 0 ≤ y ≤ 1; 0 ≤ z ≤ 0,5 und 0 ≤ x+y+z ≤ 1, H_{(1-x-y-z)}LiₓNa_{y},K_{z}SbP₂O₈ mit 0 ≤ x ≤ 1; 0 ≤ y ≤ 1; 0 ≤ z ≤ 0,5 und 0 ≤ x+y+z ≤ 1, einem lamellaren Oxid, einem lamellaren Perowskit, einem lamellaren Phosphat, einem lamellaren Sulfid, einem lamellaren Halogenid, einem lamellaren Karbid und deren Mischungen,
wobei die Zusammensetzung durch Mischen der geladenen lamellaren Verbindung mit einer Lösung, die das neutrale Tensid umfasst, erhalten werden kann,
wobei die Konzentration des neutralen Tensids in dieser Lösung unterhalb der kritischen Mizellkonzentration (CMC) des neutralen Tensids liegt.

13. Flüssige Zusammensetzung nach Anspruch 12, wobei das neutrale Tensid ein nichtionisches Tensid ist, gewählt aus einem ethoxylierten Alkohol, einem ethoxylierten Alkylphenol, einer ethoxylierten Fettsäure, einem ethoxylierten Monoalkoholamid, einem ethoxylierten Sorbitanester, einem ethoxylierten Amin, einem Glykolester, einem Glycerinester, einem Polycerinester, einem Sorbitolester, einem Glucosid, einem Polyglucosid wie beispielsweise einem alkylierten Polyglucosid, einem Saccharoseester, einem Aminoxid wie beispielsweise Lauryldimethylaminoxid oder einem Blockcopolymer, das mindestens einen amphiphilen Block umfasst.

14. Flüssige Zusammensetzung nach Anspruch 13, wobei das nichtionische Tensid ein Blockcopolymer ist, das wenigstens einen amphiphilen Block umfasst, gewählt aus Blöcken mit Fluoreinheit, Blöcken mit biologischer Einheit, Blöcken mit Dendrimer-Einheit und Blöcken mit Poly(alkylenoxid)-Einheit.

## Claims

1. Method for depositing a film on a substrate from a liquid composition, comprising the following steps:
a) forming a film from the liquid composition,
b) bringing the film into contact with the substrate, and
c) depositing the film on the substrate
**characterised in that** the liquid composition comprises a neutral surfactant and a charged layered compound,
the liquid composition is obtained by mixing the charged layered compound with the neutral surfactant, and
the concentration of neutral surfactant before mixing with the charged layered compound is lower than the critical micelle concentration (CMC) of said neutral surfactant.

2. Deposition method according to claim 1, wherein the neutral surfactant is selected from a nonionic surfactant, a zwitterionic surfactant, an amphoteric surfactant and mixtures thereof.

3. Deposition method according to claim 2, wherein the neutral surfactant is a nonionic surfactant selected from an ethoxylated alcohol, an ethoxylated alkylphenol, an ethoxylated fatty acid, an ethoxylated monoalkanolamide, an ethoxylated sorbitan ester, an ethoxylated amine, a glycol ester, a glycerol ester, a polyglycerol ester, a sorbitol ester, a glucoside, a polyglucoside, a sucrose ester, an amine oxide, a block copolymer comprising at least one amphiphilic block and mixtures thereof.

4. Deposition method according to claim 3, wherein the nonionic surfactant is a block copolymer comprising at least one amphiphilic block selected from fluorinated unit blocks, biological unit blocks, dendrimer unit blocks, and poly(alkylene oxide) unit blocks.

5. Deposition method according to any one of claims 1 to 4, wherein the charged layered compound is selected from a layered clay, a layered hydroxide, a layered double hydroxide, H_{3(1-x-y-z)}Li₃ₓNa₃yK_{3z}Sb₃P₂O₁₄ with 0 ≤ x ≤ 1; 0 ≤ y ≤ 1; 0 ≤ z ≤ 0.5 and 0 ≤ x+y+z ≤ 1, H_{(1-x-y-z)}LiₓNa_{y}K_{z}SbP₂O₈ with 0 ≤ x ≤ 1; 0 ≤ y ≤ 1; 0 ≤ z ≤ 0.5 and 0 ≤ x+y+z ≤ 1, a layered oxide, a layered perovskite, a layered phosphate, a layered sulphide, a layered halide, a layered carbide and mixtures thereof.

6. Deposition method according to any one of claims 1 to 5, wherein the substrate is an organic substrate or an inorganic substrate.

7. Deposition method according to claim 6, wherein the organic substrate is selected from a polymer, biological material, an organic semiconductor, and an organic light-emitting diode.

8. Deposition method according to claim 6, wherein the inorganic substrate is selected from a ceramic, an aluminium oxide, a silicon substrate, a semiconductor material, a metal, and a light-emitting diode.

9. Deposition method according to any one of claims 1 to 8, wherein the neutral surfactant is a compound with the formula (PEO)_{w}-(PPO)_{y}-(PEO)_{z}, where w is between 5 and 300 and y is between 33 and 300 and z is between 5 and 300, the charged layered compound is H_{3(1-x-y-z)}Li₃ₓNa₃yK_{3z}Sb₃P₂O₁₄ with 0 ≤ x ≤ 1; 0 ≤ y ≤ 1; 0 ≤ z ≤ 0.5 and x+y+z =1, and the substrate is a protein crystal.

10. Deposition method according to any one of claims 1 to 9, wherein steps a) to c) are repeated.

11. Method for analysing a substrate on which a film is deposited, comprising the steps of the method for depositing a film as defined according to any one of claims 1 to 10 and a step d) of analysing the substrate on which a film is deposited.

12. Liquid composition comprising a neutral surfactant and a charged layered compound, wherein:
- the neutral surfactant is selected from a nonionic surfactant, a zwitterionic surfactant, an amphoteric surfactant and mixtures thereof, and
- the charged layered compound is selected from a layered clay, a layered hydroxide, a layered double hydroxide, H_{3(1-x-y-z)}Li₃ₓNa_{3y}K_{3z}Sb₃P₂O₁₄ with 0 ≤ x ≤ 1; 0 ≤ y ≤ 1; 0 ≤ z ≤ 0.5 and 0 ≤ x+y+z ≤ 1, H_{(1-x-y-z)}LiₓNa_{y}K_{z}SbP₂O₈ with 0 ≤ x ≤ 1; 0 ≤ y ≤ 1; 0 ≤ z ≤ 0.5 and 0 ≤ x+y+z ≤ 1, a layered oxide, a layered perovskite, a layered phosphate, a layered sulphide, a layered halide, a layered carbide and mixtures thereof,
said composition being obtainable by mixing the charged layered compound with a solution comprising the neutral surfactant, the concentration of neutral surfactant in this solution being less than the critical micelle concentration (CMC) of said neutral surfactant.

13. Liquid composition according to claim 12, wherein the neutral surfactant is a nonionic surfactant selected from an ethoxylated alcohol, an ethoxylated alkylphenol, an ethoxylated fatty acid, an ethoxylated monoalkaolamide, an ethoxylated sorbitan ester, an ethoxylated amine, a glycol ester, a glycerol ester, a polyglycerol ester, a sorbitol ester, a glucoside, a polyglucoside such as an alkyl polyglucoside, a sucrose ester, an amine oxide such as lauryldimethylamine oxide, a block copolymer comprising at least one amphiphilic block.

14. Liquid composition according to claim 13, wherein the nonionic surfactant is a block copolymer comprising at least one amphiphilic block selected from fluorinated unit blocks, biological unit blocks, dendrimer unit blocks, and poly(alkylene oxide) unit blocks.
